# EUROPEAN PATENT SPECIFICATION

(11) **EP 0 751 572 B1**
(45) Date of publication and mention of the grant of the patent: **22.08.2007**
(21) Application number: 96304747.7
(22) Date of filing: 27.06.1996
(51) Int. Cl.: H01L 27/02

(54) **High voltage integrated circuit and level shift unit**
Integrierte Hochspannungsschaltung und Pegelverschiebungseinheit
Circuit intégré à haute tension et unité de décalage de niveau

(30) Priority: 28.06.1995 JP 16213995; 05.10.1995 JP 25847295
(43) Date of publication of application: 02.01.1997
(73) Proprietor: FUJI ELECTRIC CO. LTD., Kawasaki 210 (JP)
(72) Inventor: Fujihira, Tatsuhiko, Kawasaki-ku, Kawasaki 210 (JP)
(74) Representative: Bridge-Butler, Alan James

(56) References cited:
- EP-A- 0 542 460
- EP-A- 0 596 565
- US-A- 4 890 146

## Description

The present invention relates to a high voltage integrated circuit used for controlling and driving a power device, and in particular to a high voltage integrated circuit formed on a semiconductor substrate independent of the power device, or on the same semiconductor substrate on which the power device is provided.

Power devices have been widely used in many applications including inverters or converters for controlling motors, inverters for illumination, various power sources, and switches for driving solenoids and relays. The power devices were conventionally driven and controlled by electronic circuits constructed as a combination of individual semiconductor devices and electronic components. These functions have been more recently performed by low voltage integrated circuits of several dozens of volts class or high voltage integrated circuits of several hundreds of volts, which utilize recent LSI (large scale integration) technology. Power integrated circuits in which drive and control circuits and power devices are integrated on the same semiconductor substrate are also used to reduce the size of conversion devices, such as inverters and converters, and achieve high operating reliability thereof.

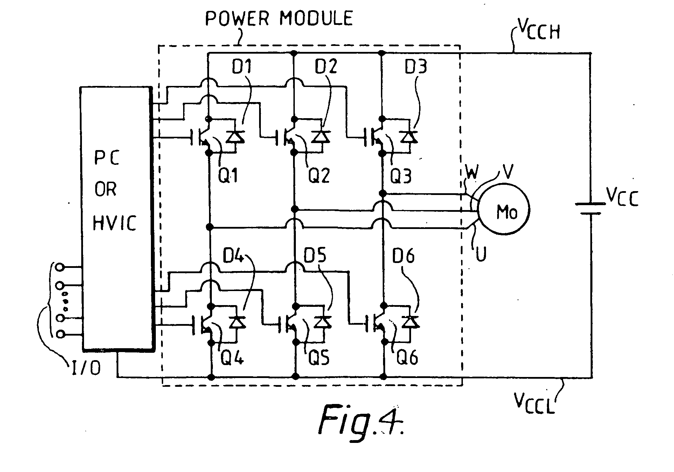

Figure 4 is a circuit diagram mainly showing a power-related portion of an inverter for controlling a motor. Power devices (Q1 to Q6 as IGBTs -insulated gate bipolar transistor- and D1 to D6 as diodes in this example) used for driving a three-phase motor Mo form a bridge circuit, and are all stored in the same package to provide a power module. The main power source V_{CC} usually provides a high voltage of DC 100 to 400 volts. V_{CCH} represents the high-potential side of the main power source V_{CC}, and V_{CCL} represents the low-potential side of the main power source Vcc. To drive IGBTs Q1 to Q3 connected to the V_{CCH}, the potential of gate electrodes of the IGBTs Q1 to Q3 needs to be higher than the V_{CCH}. Accordingly, the drive circuit is provided with a photocoupler (PC) or a high voltage integrated circuit (HVIC). The input and output terminals (I/O) of the drive circuit are usually connected to a microcomputer adapted for controlling the inverter as a whole.

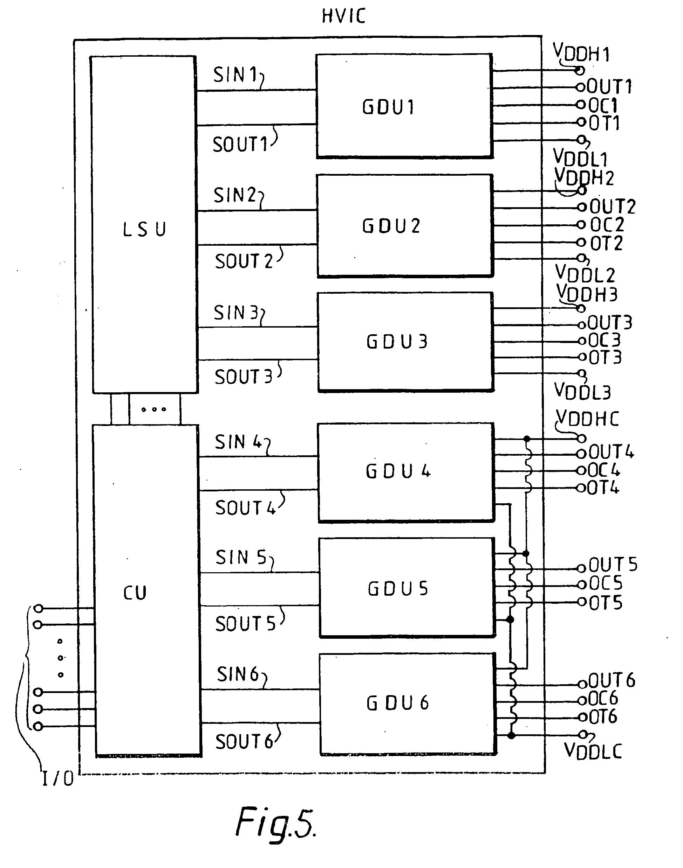

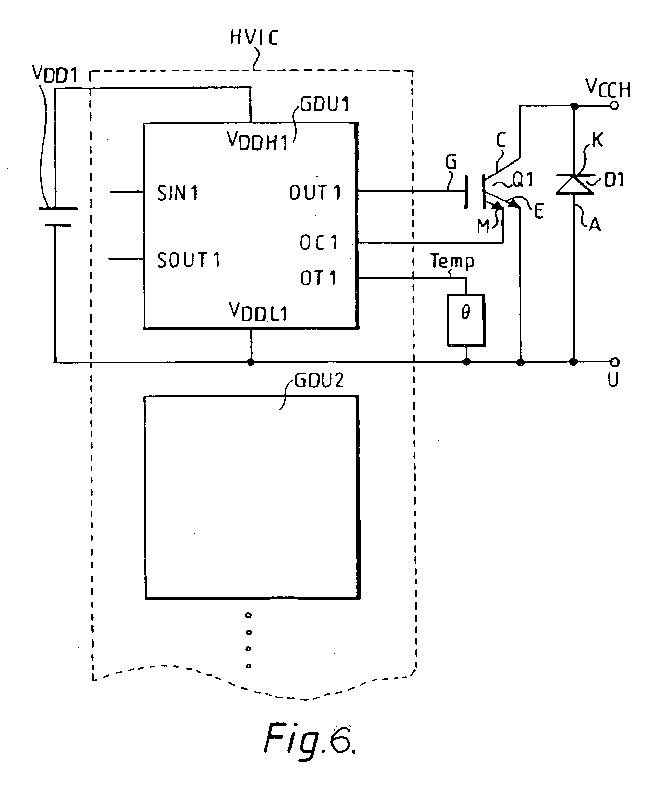

Figure 5 is a block diagram showing constituent units of the high voltage integrated circuit (HVIC) used in the circuit of Figure 6. This circuit includes a control unit CU, gate drive units GDU and a level shift unit LSU. The control unit sends and receives signals to and from a microcomputer, through the input and output terminals I/O, to generate control signals for turning on and off selected one(s) of the IGBTs. The gate drive units GDU 4 to 6 receive signals from the control circuit CU through input lines SIN 4 to 6 and generate signals to output lines SOUT 4 to 6 for driving gates of the corresponding IGBTs. Each of the gate drive units GDU 4 to 6 also detects excessive current and heat of the IGBT with a current detecting terminal OC 4 to 6 and a temperature terminal OT 4 to 6, and generates abnormal signals through a corresponding output line SOUT 4 to 6. In this manner, the gate drive units GDU 4 to 6 drive the corresponding IGBTs Q4 to Q6 connected to the low-potential side V_{CCL} of the main power source Vccof Figure4. The gate drive units GDU1 to GDU3 perform the same functions as the gate drive units GDU4 to GDU6, to drive corresponding IGBTs Q1 to Q3 that are connected to the high-potential side V_{CCH} of the main power source Vcc. The level shift unit LSU functions as an interface between the V_{CCL}-level signals of the control circuit CU, and the signals (SIN 1 to 3, SOUT 1 to 3) of GDU 1 to 3 which fluctuate between the V_{CCH} level and the V_{CCL} level. Drive power sources (shown in Figure 6) V_{DD1} to V_{DD3} for the GDU 1 to 3 have respective high-potential sides V_{DDH1} to V_{DDH3} and low-potential sides V_{DDL1} to V_{DDL3}. The GDU 4 to 6 are connected to a common drive power source V_{DDC} (not shown in Figure 6), which has a high-potential side V_{DDHC} and a low-potential side V_{DDLC}. The common drive power source V_{DDC} for the GDU 4 to 6 and CU is about 10 to 20V, and the low-potential side V_{DDLC} of this common power source V_{DDC} is connected to the low-potential side V_{CCL} of the main power source Vcc of Figure 4.

Figure 6 shows in greater detail the connection between the GDU1 of Figure 5 and the IGBT Q1, by way of example. The other GDUs and IGBTs are not shown in this Figure. The drive power source V_{DD1} of the GDU1 is about 10 to 20 volts. The low-potential side V_{DDL1} of this power source is connected to an emitter terminal E of IGBT Q1, namely, a U phase of inverter output, and a collector terminal C of the IGBT Q1 is connected to the high-potential side V_{CCH} of the main power source Vcc. In this arrangement, when the IGBT Q1 is turned on, the potential of V_{DDL1} is made substantially equal to the potential of V_{CCH}. When the IGBT Q1 is turned off, the potential Of V_{DDL1} is made substantially equal to the potential of V_{CCL}. Accordingly, the withstand voltage between the GDU1 and other circuit units needs to be higher than the voltage of the main power source Vcc. This also applies to GDU2 and GDU3. Further, the level shift unit LSU itself must have high withstand voltage. In Figure 6, the IGBT Q1 includes a current detecting element M, a temperature detecting element θ, and a temperature detecting terminal Temp. The gate drive unit GDU1 detects abnormal states of the IGBT Q1, through the current detecting terminal OC1 and the temperature detecting terminal OT1, and abnormal signals are generated through the output line SOUT 1. OUT 1 indicates a gate drive terminal.

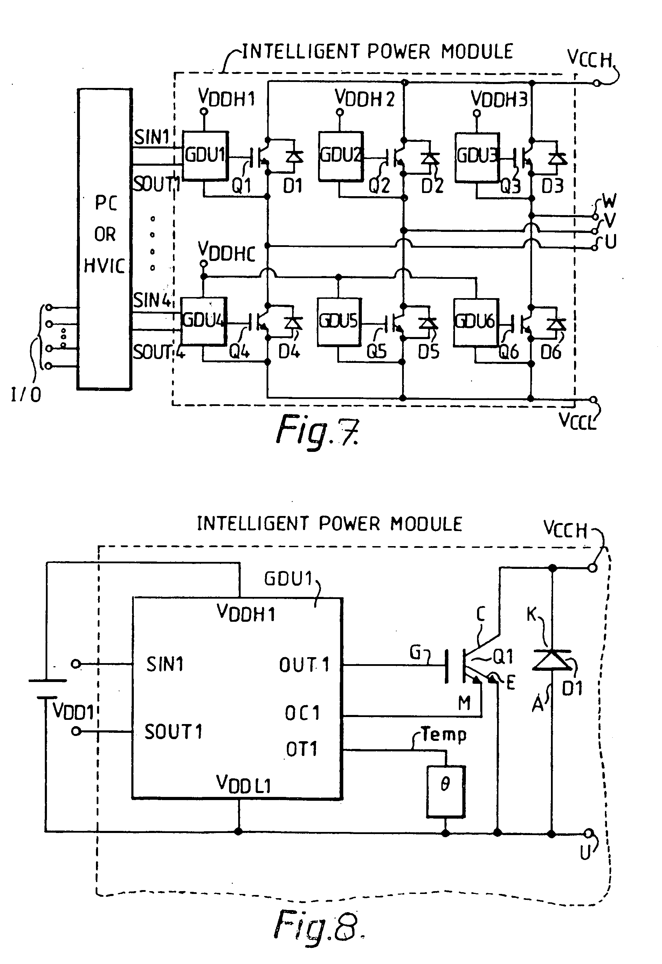

Figure 7 is a circuit diagram showing substantially the same circuit as that of Figure 4, except the use of a product called an "intelligent power module". In this case, the gate drive units GDU1 to GDU6 consist of low voltage integrated circuits, individual electronic components and semiconductor devices, and are stored along with power devices (Q1 to Q6, D1 to D6) in a package containing the power devices. In this case, too, a photocoupler PC or high voltage integrated circuit HVIC is used as an exterior drive circuit.

Figure 8 shows in detail the vicinity of IGBT Q1 and GDU1 of Figure7. SIN1 and SOUT1 are connected to the PC or HVIC provided outside of the power module.

To provide other structures, power IC technology for integrating the GDU1 and Q1 on one chip (on the same semiconductor substrate), or power IC technology for integrating all the units of Figure 7 in one chip can be employed.

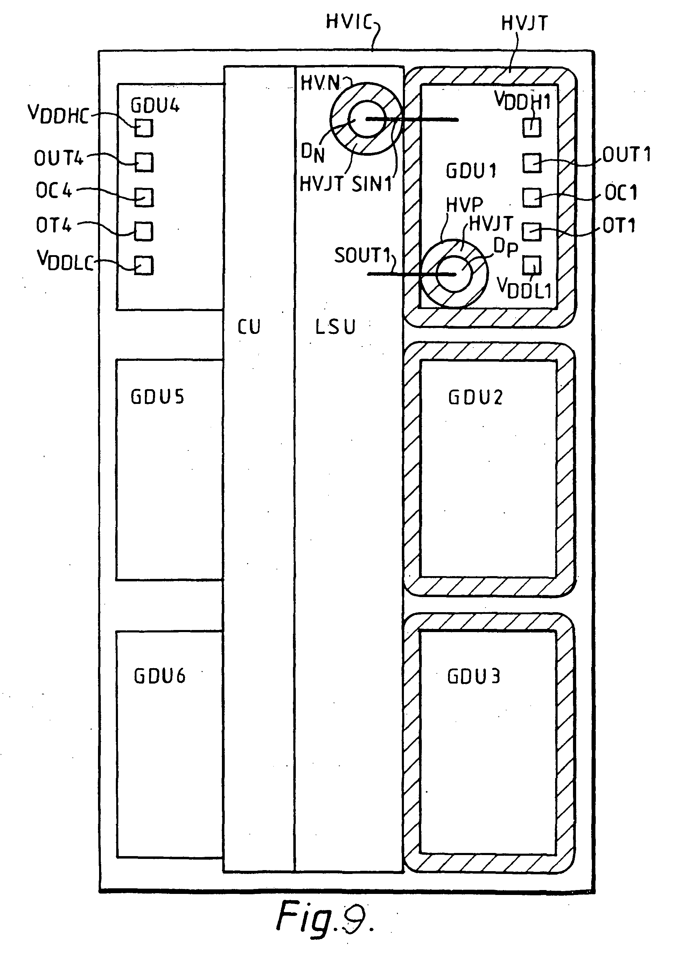

Figure 9 is a plan view showing a chip of the high voltage integrated circuit HVIC shown in Figure 5, to clarify the arrangement of circuit units constituting the circuit. The GDU1 is formed in an island electrically separated from the other circuit units by junction separation or dielectric separation to assure high withstand voltage, and the periphery of this GDU1 is surrounded by a high voltage junction terminating structure HVJT. The HVJT is a structure of a terminating part of the junction to which high voltage is applied to insulate the unit therein from the other units. Within the level shift unit LSU, there is provided a high voltage n-channel MOSFET (HVN) adapted for shifting a level of signals having the potential V_{CCL} on the low-potential side of the main power source Vcc, to a level of signals (to be fed to the input line SIN1) having the potential V_{DDL1} on the low-potential side of the drive power source V_{DD1}. This high voltage n-channel MOSFET is provided with a high voltage junction terminating structure HVJT surrounding a drain electrode D_{N} at the centre of the MOSFET. Within the island of the GDU1. Q there is provided a high voltage p-channel MOSFET (HVP) adapted for shifting the V_{DDL1} level of signals (received from the output line SOUT1), to the V_{CCL} level of signals. This high voltage p-channel MOSFET is also provided with a high voltage junction terminating structure HVJT surrounding a drain electrode D_{P} at the centre of the MOSFET. The input line SIN1 and output line SOUT1 of the GDU1 are installed to extend between GDU1 and LSU, over the high voltage junction terminating structure HVJT. Each of the GDUs is provided with an OUT terminal, OC terminal and OT terminal as shown in Figure 6. GDU1 to GDU3 are provided with respective V_{DDH1} to V_{DDH3} terminals, and V_{DDL1} to V_{DDL3} terminals, and GDU4 to GDU6 are provided with V_{DDHC} terminals and V_{DDLC} terminals. In Figure 11, the arrangements of these elements of the GDU1 and GDU4 are shown in detail, and those of the other GDUs are not shown.

Problems encountered in the conventional high voltage integrated circuit and power IC include the difficulty in providing high withstand voltage exceeding 600V, and high manufacturing cost. The problems will be described in more detail.

### (1) Problems relating to separation techniques.

As described above, separation techniques for electrically separating a circuit unit (e.g., GDU 1, 2, 3 shown in Figure 9) having a greatly different potential from other units include dielectric separation, junction separation, and self separation. The structures for enabling dielectric separation and junction separation, however, are complicated, and require high manufacturing cost. The manufacturing cost is further increased with an increase in the withstand voltage required. Although the manufacturing cost can be reduced by employing self separation, technology has not been developed for achieving high withstand voltage in the structure of CMOS (complementary MOSFET). In the structure of NMOS (n-channel MOSFET) capable of providing high withstand voltage, it is extremely difficult to achieve sufficiently high accuracy of analogue circuits (i.e., the current detecting circuit and temperature detecting circuit as described above).

### (2) Problems relating to high voltage junction terminating structure HVJT.

Various kinds of high voltage junction terminating structures have been disclosed that include those for vertical power devices, and for lateral high voltage devices. In a high voltage power IC in which the high voltage integrated circuit and power devices are integrated, however, high voltage junction terminating structures for many applications, such as those (surrounding GDU 1 to 3 in Figure 9) formed between integrated circuit units, those (surrounding D_{N} of HVN in Figure 9) for high voltage lateral n-channel MOSFETs, those (surrounding D_{P} of HVP in Figure 9) for high voltage lateral p-channel MOSFETs, and those for vertical power devices, need to be formed on the same chip. With the conventional high voltage IC or power IC constructed for limited applications, many different kinds of high voltage junction terminating structures HVJT must be formed on the same chip, resulting in increased manufacturing cost.

### (3) Problems relating to high voltage junction terminating structure on which wiring is provided.

In the high voltage IC in which signals travel between integrated circuit units (e.g., GDU1 and LSU of Figure 9) having greatly different potentials, wiring needs to be provided on the high voltage junction terminating structure HVJT. In this case, however, the high voltage junction terminating structure HVJT may be influenced by the potential of the wiring provided thereon, resulting in reduced withstand voltage of the HVJT. Although various structures have been proposed to solve this problem, these structures are complicated, and are only available at high manufacturing cost. Also, these proposed structures are not completely free from the influence of wiring, and are merely able to prevent reduction of the withstand voltage to a limited extent. Thus, the known structures can provide a withstand voltage of up to about 600V, but cannot achieve a higher withstand voltage.

EP-A-0 596 565 shows a device which includes movable HV - LDMOS transistors and a floating well circuit. It shows a first high voltage junction terminating structure formed as an enclosed loop (p⁺ 41) which is arranged within another high voltage terminating structure which is also formed as an enclosed loop but these terminating structures can be considered to be one region because they are the same p type. They are connected together in one region and have the same electrical potential but the connection between them does not extend over their surfaces. The n⁺ source is located within the first voltage junction terminating structure. In other words the two high voltage junction terminating structures are not spaced apart.

US 4 890 146 A also shows a high voltage terminating structure which has a guard ring 7 over which wiring extends but the wiring only extends over a single high voltage junction terminating structure and does not extend over a similar structure.

It is therefore an object of the present invention to provide a high voltage integrated circuit at a reduced cost, and a high voltage level shift unit used for such a high voltage integrated circuit.

The above object may be accomplished according a first aspect of the present invention, which comprises a high voltage integrated circuit high voltage junction terminating structures (HVJT) shaped like a loop, characterised in that a signal wiring extends over said two or more high voltage junction terminating structures (HVJT) and said signal wiring is spaced apart from surfaces of said two or more high voltage junction terminating structures (HVJT).

In a preferred construction the high voltage integrated circuit (HVIC) includes a high voltage IC (HVIC) for driving each gate (G) of at least one power device (Q1-Q6) having main terminals (C, E), one (C) of which is connected to a high potential side (V_{CCH}) of a high voltage source, and the other (E) of which is connected to a load, characterised by: comprising a low potential side low voltage circuit portion (LSU) to which current is supplied by a low voltage source based on a low potential side of a high voltage source; a high potential side low voltage circuit portion (GDU1) to which current is supplied by a low voltage source based on one of said main terminals of each of said at least one power device, a first high voltage junction terminating structure (HVJT) in the form of an enclosed loop, for separating said low potential side low voltage circuit portion (LSU) from said high potential side low voltage circuit portion (GDU1); a high voltage transistor (HVP or HVN) for shifting a level of signals between said high potential side low voltage circuit portion (GDU1) and said low potential side low voltage circuit portion (LSU) for transmission, the high voltage transistor (HVP or HVN) provided in one of said high potential side low voltage circuit portion (GDU1) and said low potential side low voltage circuit portion (LSU); a second high voltage junction terminating structure (HVJT2 or HVJT1) in the form of an enclosed loop provided in said high voltage transistor (HVP or HVN) such that a drain (collector) electrode of the high voltage transistor is located inside of the loop of said second high voltage junction terminating structure (HVJT2 or HVJT1), and a source (emitter) electrode and a gate (base) electrode are located outside of the loop of said second high voltage junction terminating structure (HVJT2 or HVJT1); and a signal wiring extending from said drain electrode of said high voltage transistor (HVP or HVN) to one of said low potential side low voltage circuit portion (LSU) and said high potential side low voltage circuit portion (GDU1), extending over said first (HVJT) and second (HVJT2 or HVJT1) high voltage junction terminating structures, said signal wiring being spaced apart from surfaces of said first (HVJT) and second (HVJT2 or HVJT1) high voltage junction terminating structures.

In the high voltage integrated circuit said high voltage transistor (HVN) can be a high voltage n-channel transistor for shifting a level of signals from said low potential side low voltage circuit portion (LSU) for transmission to said high potential side low voltage circuit portion (GDU1).

The high voltage transistor (HVP) may comprise a high voltage p-channel transistor for shifting a level of signals from said high potential side low voltage circuit portion (GDU1) for transmission to said low potential side low voltage circuit portion (LSU).

Preferably the said signal wire (SIN1 or SOUT1) comprises a bonding wire.

The said high voltage transistor (HVP) (HVN) can comprise a MOSFET.

In a preferred construction the distance between said signal wiring (SIN1 or SOUT1) and one end of said first high voltage junction terminating structure (HVJT) on said high potential side low voltage circuit portion (GDU1), and a distance between said signal wiring (SIN1 or SOUT1) and one of said second high voltage junction terminating structure (HVJT2 or HVJT1) on said high potential side low voltage circuit portion (GDU1) are both not less than 100µm and not greater than 5mm.

In the above description, the source, gate and drain electrodes are employed if the high voltage n- or p-channel transistor is a MOSFET, and the emitter, base and collector electrodes are employed if the transistor is another type.

In the above-indicated phrase that "the high potential side low voltage circuit portion to which current is supplied by a low voltage source having a reference potential point based on one of the main terminals of each power device", the "one of the main terminals" means the terminal connected to the load in the case where the power device on the high potential side is an n-channel device, and means the terminal connected to the power source in the case where the power device is a p-channel device. When the low voltage source has a reference potential point based on one of the main terminals of the power device, the source (emitter) electrode becomes the reference potential point (so-called earth point).

The invention will be described in greater detail with reference to certain preferred embodiments thereof and the accompanying drawings, wherein:
Figure 1A and Figure 1B are plan and side views, respectively, showing a first embodiment of the present invention;
Figure 2A and Figure 2B are plan view side views, respectively, showing a second embodiment of the present invention;
Figure 3A and Figure 3B are plan and side views, respectively, showing a third embodiment of the present invention;
Figure 4 is a circuit diagram mainly showing a power-related portion of an inverter for controlling a motor;
Figure 5 is a block diagram showing the interior of a high voltage integrated circuit used in the circuit of Figure 4;
Figure 6 is a view showing in detail the connection between GDU1 of Figure 7 and IGBT Q1;
Figure 7 is a circuit diagram showing a similar circuit to that of Figure 6, using a product called an "intelligent power module";
Figure 8 is a view showing in detail a circuit in the vicinity of the IGBT Q1 and GDU1 of Figure7; and,
Figure 9 is a plan view showing a high voltage IC chip as shown in Figure 5.

In the following description, the same symbols or characters as used in the introduction will be used for identifying corresponding elements structurally and/or functionally, and no repetition of the detailed explanation of these elements will be provided.

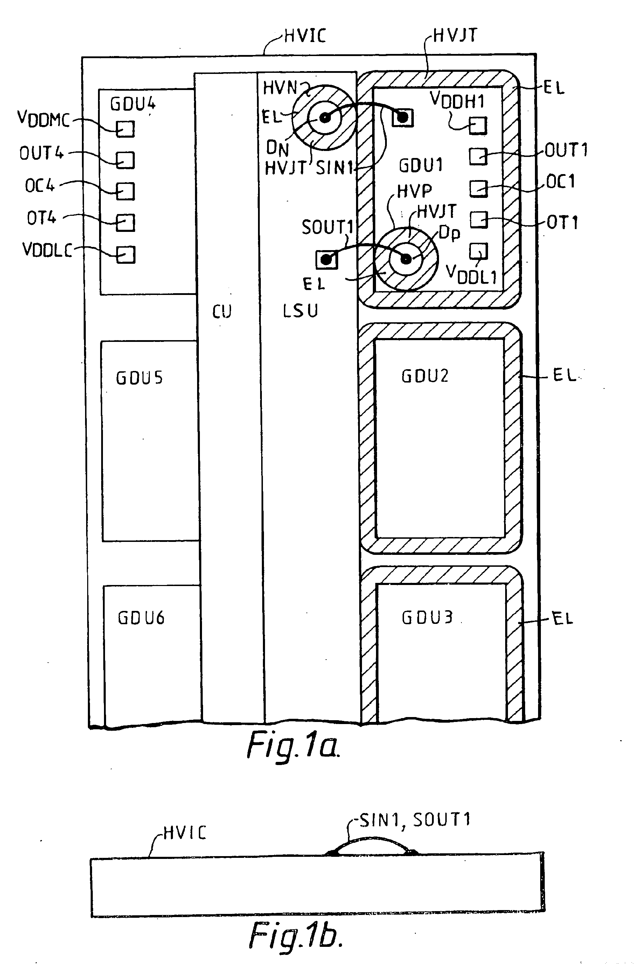

Figures 1A and 1B are a plan view and a side view, respectively, showing a high voltage integrated circuit (HVIC), wherein a high voltage junction terminating structure HVJT is provided for each of the gate drive units GDU1 to GDU3 which are high potential side low voltage circuits, a high voltage n-channel MOSFET (HVN), and a high voltage p-channel MOSFET (HVP). The drain electrode D_{N} of the high voltage n-channel MOSFET (HVN) and the GDU1, and the drain electrode D_{P} of the high voltage p-channel MOSFET (HVN) and the LSU are connected to each other by SIN1 and SOUT1, respectively. These SIN1 and SOUT1 are formed by bonding wires, such as gold wires. The outer end of each of the high voltage junction terminating structures HVJT for GDU1 to GDU3 and the outer end of each of the high voltage junction terminating structures HVJT for HVN, HVP are spaced not less than 100µm apart from the corresponding bonding wire, whereby the space capacity (floating capacity) can be reduced to one tenth of that of the conventional circuit. Although the space capacity can be reduced with an increase in the spacing between the HVJT and the bonding wire, this spacing is practically not larger than about 5mm, and usually set at around 1mm. The above-indicated outer end of the high voltage junction structure HVJT for GDU1 to GDU3 and HVN is a point of contact thereof with a low potential side low voltage circuit. The outer end of the high voltage junction structure HVJT for HVP means a point of contact thereof with the high potential side low voltage circuit.

Each of the high voltage terminating structures (HVJT) is formed as an enclosed loop indicated by reference letters EL.

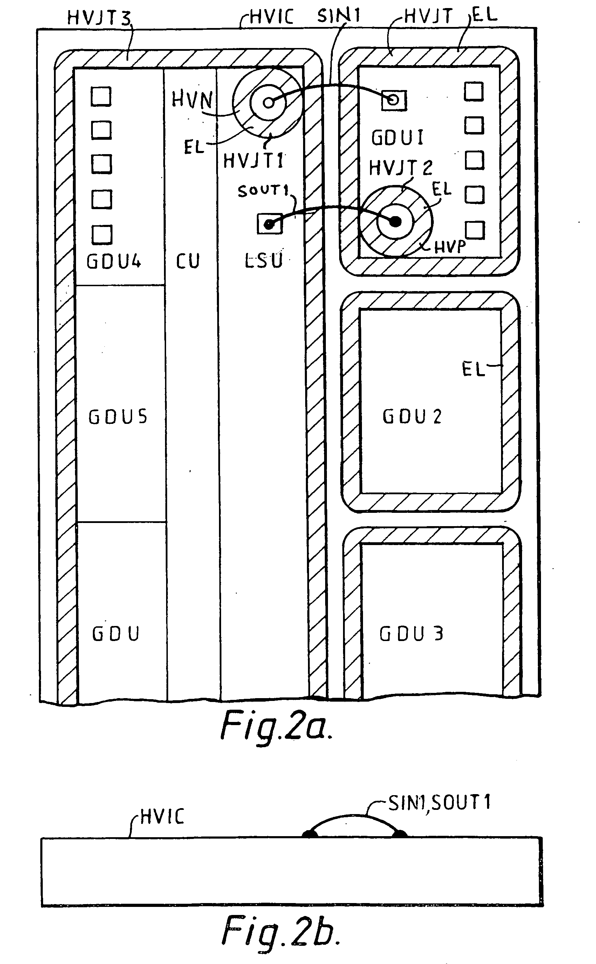

Figures 2A and 2A are a plan view and a side view, respectively, showing a high voltage integrated circuit (HVIC), wherein a high voltage junction terminating structure HVJT3 provided for each of a low potential side low voltage circuit which consists of the gate drive units GDU4 to GDU6, CU and LSU; the gate drive units GDU1 to GDU3, the high voltage n-channel MOSFET (HVN) (HVJT1), and the high voltage p-channel MOSFET (HVP) (HVJT2). The high voltage n-channel MOSFET (HVN) (HVJT1) and GDU1, and the high voltage p-channel MOSFET (HVP) (HVJT2) and LSU are connected to each other by SIN1 and SOUT1, respectively. These SIN1 and SOUT1 consist of bonding wires, such as gold wires. The outer end of each of the high voltage junction terminating structures HVJT for GDU1 to GDU3, and the outer end of each of the high voltage junction terminating structures HVJT for HVN and HVP are spaced not less than 100µm apart from the corresponding bonding wire, so as to yield the same effects as described above.

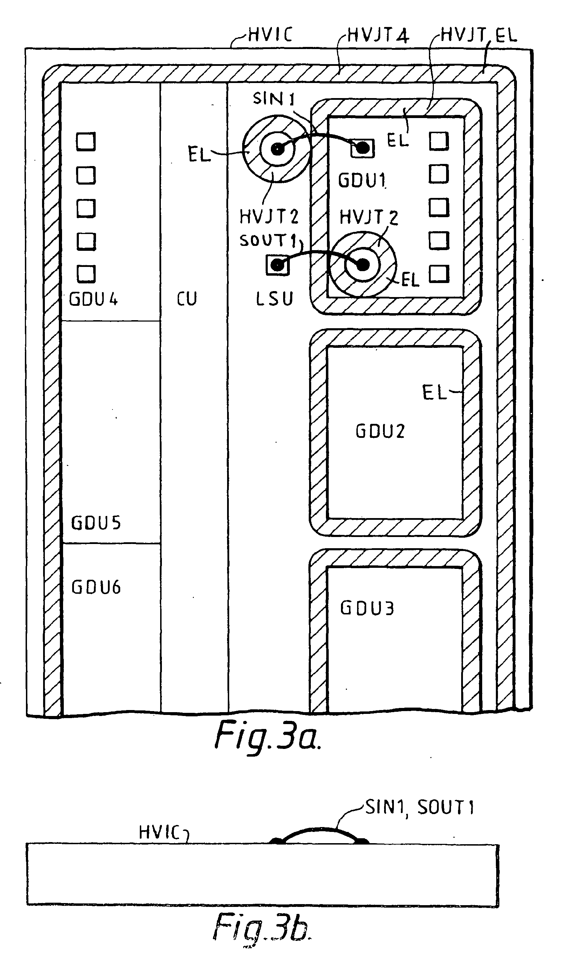

Figures 3A and 3B are a plan view and a side view, respectively, showing a high voltage integrated circuit (HVIC), wherein a high voltage junction terminating structure HVJT4 is provided to surround a chip on which GDU1 to GDU6, LSU and CU are formed, and also provided for each of the gate drive units GDU1 to GDU3, high voltage n-channel MOSFET (HVN) (HVJT1), and high voltage p-channel MOSFET (HVP). The high voltage n-channel MOSFET (HVN) and GDU1, and the high voltage p-channel MOSFET (HVP) and LSU are connected to each other by SIN1 and SOUT1, respectively. These SIN1 and SOUT1 consist of bonding wires, such as gold wires. The outer end of each of the high voltage junction terminating structures HVJT for GDU1 to GDU3, and the outer end of each of the high voltage junction terminating structures HVJT for HVN and HVP are spaced not less than 100µm apart from the corresponding bonding wire, so as to yield the same effects as described above.

In the expression "the high potential side low voltage circuit portion to which current is supplied by a low voltage source having a reference potential point based on one of the main terminals of each power device", appearing in the introductory part of the specification, the "one of the main terminals" means the terminal connected to the load in the case where the power device on the high potential side is an n-channel device, and means the terminal connected to the power source in the case where the power device is a p-channel device. When the low voltage source has a reference potential point based on one of the main terminals of the power device, the source (emitter) electrode becomes the reference potential point (so-called earth point).

While a MOSFET is suitably used as the high voltage n-channel or p-channel transistor, a JFET (junction type field-effect transistor), a bipolar transistor, an IGBT (insulated gate bipolar transistor), a SIT (static induction transistor), and other type of transistor may also be used.

While gold wires are used for signal wiring, such as SIN1, SOUT1, in the illustrated embodiments, aluminium wires may also be used. When the signal wiring is spaced not less than 100µm apart from the side of the high voltage junction terminating structure HVJT on which the potential is greatly different from that of the signal wiring, the potential of the signal wiring has almost no influence on the high voltage junction terminating structure HVJT, causing no electrical discharge between the signal wiring and the high voltage junction terminating structure HVJT.

According to the present invention, highly efficient high voltage integrated circuit and high voltage level shift units can be provided at a reduced cost. Further, a highly efficient drive circuit for a power device can be provided at a reduced cost, using these high voltage IC and level shift unit.

## Claims

1. A high voltage IC having two or more high voltage junction terminating structures (HVJT) shaped like a loop, **characterised in that** a signal wiring extends over said two or more high voltage junction terminating structures (HVJT) and said signal wiring is spaced apart from surfaces of said two or more high voltage junction terminating structures (HVJT).

2. A high voltage IC as defined in claim 1, the high voltage IC for driving each gate (G) of at least one power device (Q1-Q6) having main terminals (C, E), one (C) of which is connected to a high potential side (VCCH) of a high voltage source, and the other (E) of which is connected to a load, **characterised by**: comprising a low potential side low voltage circuit portion (LSU) to which current is supplied by a low voltage source based on a low potential side of a high voltage source; a high potential side low voltage circuit portion (GDU1) to which current is supplied by a low voltage source based on one of said main terminals of each of said at least one power device, a first high voltage junction terminating structure (HVJT) in the form of an enclosed loop, for separating said low potential side low voltage circuit portion (LSU) from said high potential side low voltage circuit portion (GDU1); a high voltage transistor (HVP or HVN) for shifting a level of signals between said high potential side low voltage circuit portion (GDU1) and said low potential side low voltage circuit portion (LSU) for transmission, the high voltage transistor (HVP or HVN) provided in one of said high potential side low voltage circuit portion (GDU1) and said low potential side low voltage circuit portion (LSU); a second high voltage junction terminating structure (HVJT2 or HVJT1) in the form of an enclosed loop provided in said high voltage transistor (HVP or HVN) such that a drain (collector) electrode of the high voltage transistor is located inside of the loop of said second high voltage junction terminating structure (HVJT2 or HVJT1), and a source (emitter) electrode and a gate (base) electrode are located outside of the loop of said second high voltage junction terminating structure (HVJT2 or HVJT1); and a signal wiring extending from said drain electrode of said high voltage transistor (HVP or HVN) to one of said low potential side low voltage circuit portion (LSU) and said high potential side low voltage circuit portion (GDU1), extending over said first (HVJT) and second (HVJT2 or HVJT1) high voltage junction terminating structures, said signal wiring being spaced apart from surfaces of said first (HVJT) and second (HVJT2 or HVJT1) high voltage junction terminating structures.

3. A high voltage IC as defined in claim 2, **characterised in that** said high voltage transistor (HVN) is a high voltage n-channel transistor for shifting a level of signals from said low potential side low voltage circuit portion (LSU) for transmission to said high potential side low voltage circuit portion (GDU1).

4. A high voltage IC as defined in claim 2, **characterised in that** said high voltage transistor (HVP) comprises a high voltage p-channel transistor for shifting a level of signals from said high potential side low voltage circuit portion (GDU1) for transmission to said low potential side low voltage circuit portion (LSU).

5. A high voltage IC as defined in claim 2, **characterised in that** said signal wiring (SIN1 or SOUT1) comprises a bonding wire.

6. A high voltage IC as defined in claim 2, **characterised in that** said high voltage transistor (HVP or HVN) comprises a MOSFET.

7. A high voltage IC as defined in claim 2, **characterised in that** a distance between said signal wiring (SIN1 or SOUT1) and one end of said first high voltage junction terminating structure (HVJT) on said high potential side low voltage circuit portion (GDU1), and a distance between said signal wiring (SIN1 or SOUT1) and one of said second high voltage junction terminating structure (HVJT2 or HVJT1) on said high potential side low voltage circuit portion (GDU1) are both not less than 100µm and not greater than 5mm.

## Patentansprüche

1. Integrierte Hochspannungsschaltung mit zwei oder mehreren schleifenförmigen Hochspannungsübergangsabschlussstrukturen (HVJT), **dadurch gekennzeichnet, dass** sich eine Signalleitung über die zwei oder mehreren Hochspannungsübergangsabschlussstrukturen (HVJT) erstreckt und die Signalleitung von Oberflächen der zwei oder mehr Hochspannungsübergangsabschlussstrukturen (HVJT) beabstandet ist.

2. Integrierte Hochspannungsschaltung nach Anspruch 1, die integrierte Hochspannungsschaltung zum Ansteuern jedes Gates (G) von mindestens einer Leistungsvorrichtung (Q1-Q6) mit Hauptanschlüssen (C, E), wobei einer davon (C) mit einer Hochpotentialseite (VCCH) einer Hochspannungsquelle verbunden ist und der andere (E) mit einer Last verbunden ist, ist **gekennzeichnet durch**: Umfassen eines niederpotentialseitigen Niederspannungsschaltungsteils (LSU) an welches Strom **durch** eine auf einer Niederpotentialseite einer Hochspannungsquelle basierenden Niederspannungsquelle gespeist wird; ein hochpotentialseitiges Niederspannungsschaltungsteil (GDU1) an welches Strom durch eine auf einem der Hauptanschlüsse von jedem der mindestens einen Leitungsvorrichtung basierenden Niederspannungsquelle gespeist wird, eine erste Hochspannungsübergangsabschlussstruktur (HVJT) in Form einer abgeschlossenen Schleife zum Trennen des niederpotentialseitigen Niederspannungsschaltungsteils (LSU) von dem hochpotentialseitigen Niederspannungsschaltungsteil (GDU1); ein Hochspannungstransistor (HVP oder HVN) zum Verschieben eines Signalpegels zwischen dem hochpotentialseitigen Niederspannungsschaltungsteil (GDU1) und dem niederpotentialseitigen Niederspannungsschaltungsteil (LSU) für die Übertragung, der Hochspannungstransistor (HVP oder HVN) ist in dem hochspannungsseitigen Niederspannungsschaltungsteil (GDU1) oder dem niederpotentialseitigen Niederspannungsschaltungsteil (LSU) vorgesehen; eine zweite Hochspannungsübergangsabschlussstruktur (HVJT2 oder HVJT1) in Form einer abgeschlossenen Schleife, die in dem Hochspannungstransistor (HVP oder HVN) so vorgesehen ist, dass eine Drain-(Collector)-Elektrode des Hochspannungstransistors innerhalb der Schleife der zweiten Hochspannungsübergangsabschlussstruktur (HVJT2 oder HVJT1) angeordnet ist, und eine Source-(Emitter)-Elektrode und eine Gate-(Base)-Elektrode außerhalb der Schleife der zweiten Hochspannungsübergangsabschlussstruktur (HVJT2 oder HVJT1) angeordnet sind; und eine sich von der Drain-Elektrode des Hochspannungstransistors (HVP oder HVN) zu dem niederpotentialseitigen Niederspannungsschaltungsteil (LSU) oder dem hochpotentialseitigen Niederspannungsschaltungsteil (GDU1) erstreckende Signalleitung, die sich über die erste (HVJT) und zweite (HVJT2 oder HVJT1) Hochspannungsübergangsabschlussstrukturen erstreckt, wobei die Signalleitung von Oberflächen der ersten (HVJT) und zweiten (HVJT2 oder HVJT1) Hochspannungsübergangsabschlussstrukturen beabstandet ist.

3. Integrierte Hochspannungsschaltung nach Anspruch 2, **dadurch gekennzeichnet, dass** der Hochspannungstransistor (HVN) ein n-Kanal-Hochspannungstransistor zum Verschieben des Pegels von Signalen des niederpotentialseitigen Niederspannungsschaltungsteils (LSU) für die Übertragung an das hochpotentialseitige Hochspannungsschaltungsteil (GDU1) ist.

4. Integrierte Hochspannungsschaltung nach Anspruch 2, **dadurch gekennzeichnet, dass** der Hochspannungstransistor (HVP) ein p-Kanal-Hochspannungstransistor zum Verschieben des Pegels von Signalen des hochpotentialseitigen Niederspannungsschaltungsteils (GDU1) für die Übertragung an das niederpotentialseitige Niederspannungsschaltungsteil (LSU) ist.

5. Integrierte Hochspannungsschaltung nach Anspruch 2, **dadurch gekennzeichnet, dass** die Signalleitung (SIN1 oder SOUT1) einen Verbindungsdraht umfasst.

6. Integrierte Hochspannungsschaltung nach Anspruch 2, **dadurch gekennzeichnet, dass** der Hochspannungstransistor (HVP oder HVN) einen MOSFET umfasst.

7. Integrierte Hochspannungsschaltung nach Anspruch 2, **dadurch gekennzeichnet, dass** ein Abstand zwischen der Signalleitung (SIN1 oder SOUT1) und einem Ende der ersten Hochspannungsübergangsabschlussstruktur (HVJT) auf dem hochpotentialseitigen Niederspannungsschaltungsteil (GDU1) und ein Abstand zwischen der Signalleitung (SIN1 oder SOUT1) und einer der zweiten Hochspannungsübergangsabschlussstrukturen (HVJT2 oder HVJT1) auf dem hochpotentialseitigen Niederspannungsschaltungsteil (GDU1) beide nicht kleiner als 100 µm und nicht größer als 5 mm sind.

## Revendications

1. Circuit intégré à haute tension ayant deux ou plus de deux structures de terminaison de jonctions à haute tension (TJHT), en forme de boucle, **caractérisé en ce qu'**un câblage de transmission de signaux est espacé par rapport à des surfaces desdites deux ou plus de deux structures de terminaison de jonctions à haute tension (TJHT).

2. Circuit intégré à haute tension selon la revendication 1, le circuit intégré à haute tension, pour exciter chaque grille (G) d'au moins un dispositif de puissance (Q1-Q6) ayant des bornes principales (C, E), dont l'une (C) est connectée à un côté à haut potentiel (VCCH) d'une source de haute tension, et dont l'autre (E) est connectée à une charge, **caractérisé en ce que** : il comporte une partie formant circuit à basse tension (LSU) du côté à bas potentiel, à laquelle un courant est fourni par une source de basse tension reposant sur un côté à bas potentiel d'une source de basse tension ; une partie formant circuit à basse tension (GDU1) du côté à haut potentiel, à laquelle un courant est fourni par une source de basse tension reposant sur l'une desdites bornes principales du/de chacun desdits dispositifs de puissance, une première structure de terminaison de jonction à haute tension (TJHT) sous la forme d'une boucle enfermée, pour séparer ladite partie formant circuit à basse tension (LSU) du côté à bas potentiel par rapport à ladite partie formant circuit à basse tension (GDU1) du côté à haut potentiel ; un transistor à haute tension (HVP ou HVN) pour décaler un niveau de signaux entre ladite partie formant circuit à basse tension (GDU1) du côté à haut potentiel et ladite partie formant circuit à basse tension (LSU) du côté à bas potentiel pour la transmission, le transistor à haute tension (HVP ou HVN) étant disposé dans l'une parmi ladite partie formant circuit à basse tension (GDU1) du côté à haut potentiel et ladite partie formant circuit à basse tension (LSU) du côté à bas potentiel ; une deuxième structure de terminaison (HVJT2 ou HVJT1) de jonction à haute tension sous la forme d'une boucle enfermée présente dans ledit transistor à haute tension (HVP ou HVN) de telle sorte qu'une électrode de drain (collecteur) du transistor à haute tension se trouve à l'intérieur de la boucle de ladite seconde structure de terminaison (HVJT2 ou HVJT1) de jonction à haute tension, et une électrode de source (émetteur) et une électrode de grille (base) sont situées à l'extérieur de la boucle de ladite deuxième structure de terminaison de jonction à haute tension (HVJT2 ou HVJT1) ; et un câblage de transmission de signaux s'étendant depuis ladite électrode de drain dudit transistor à haute tension (HVP ou HVN) jusqu'à l'une parmi ladite partie formant circuit à basse tension (LSU) du côté à bas potentiel et ladite partie formant circuit à basse tension (GDU1) du côté à haut potentiel, s'étendant par-dessus lesdites première (TJHT) et seconde (TJHT2 ou TJHT1) structures de terminaison de jonctions à haute tension, ledit câblage de transmission de signaux étant espacé par rapport à des surfaces desdites première (TJHT) et seconde (TJHT2 ou TJHT1) structures de terminaison de jonctions à haute tension.

3. Circuit intégré à haute tension selon la revendication 2, **caractérisé en ce que** ledit transistor à haute tension (HVN) est un transistor à haute tension à canal N servant à décaler un niveau de signaux par rapport à ladite partie de circuit à basse tension (LSU) du côté à bas potentiel pour une transmission vers ladite partie formant circuit à basse tension (GDU1) du côté à haut potentiel.

4. Circuit intégré à haute tension selon la revendication 2, **caractérisé en ce que** ledit transistor à haute tension (HVP) est constitué par un transistor à haute tension à canal P pour décaler un niveau de signaux provenant de ladite partie formant circuit à basse tension (GDU1) du côté à haut potentiel afin de les transmettre à ladite partie formant circuit à basse tension (LSU) du côté à bas potentiel.

5. Circuit intégré à haute tension selon la revendication 2, **caractérisé en ce que** ledit câblage (SIN1 ou SOUT1) de signaux comporte un fil de connexion.

6. Circuit intégré à haute tension selon la revendication 2, **caractérisé en ce que** ledit transistor à haute tension (VHP ou HVN) est constitué par un TEC MOS.

7. Circuit intégré à haute tension selon la revendication 2, **caractérisé en ce qu'**une distance entre ledit câblage (SIN1 ou SOUT1) de transmission de signaux et une première extrémité de ladite première structure de terminaison de jonction à haute tension (TJHT) sur ladite partie formant circuit à basse tension (GDU1) du côté à haut potentiel, et une distance entre ledit câblage de transmission de signaux (SIN1 ou SOUT1) et l'une desdites secondes structures de terminaison de jonctions à haute tension (TJHT2 ou TJHT1) dans la partie formant circuit de basse tension (GDU1) du côté à haut potentiel sont l'une et l'autre non inférieures à 100 µm et non supérieures à 5 mm.
